# EUROPEAN PATENT APPLICATION

(11) **EP 2 182 610 A1**
(43) Date of publication of application: **05.05.2010**
(21) Application number: 08460042.8
(22) Date of filing: 31.10.2008
(51) Int. Cl.: H02J 13/00, G06F 11/30, G06F 11/32

(54) **A method and a system for monitoring and/or diagnosing electric power equipment and especially high voltage equipment**

(71) Applicant: ABB Research Ltd., 8050 Zürich (CH)
(72) Inventor: Orkisz, Michal, 30-076 Krakow (PL)
(74) Representative: Chochorowska-Winiarska, Krystyna

(57) **Abstract**

The invention deals with a method and a system for monitoring and/or diagnosing electric power equipment and especially high voltage equipment, applicable in the process of supervising electric power systems, carried out by various service centers, used to promptly inform these centers about irregularities occurring during the operation of electric power equipment.

The invention is **characterized in that** the system for monitoring and/or diagnosing electric power equipment, and especially high voltage equipment, contains a monitoring and/or diagnosing unit (2) electrically connected with the monitored and/or diagnosed piece of electric power equipment (1) which is connected with a trigger (12), and the trigger (12) is connected via a data acquisition module (3) with a notification generating module (4) which is able to communicate with a receiving device (10). Activation of the trigger (12) in case of occurrence of irregularities in the state of the electric power equipment (1) causes an automatic generation and transfer of a notification message to the receiving device (10) by means of a communications network and a network connection (9). The data acquisition module (3) contains a data acquisition block (6) collecting data about the state of the piece of electric power equipment and a notification signal-tracking block (7).

## Description

The invention deals with a method and a system for monitoring and/or diagnosing electric power equipment and especially high voltage equipment, applicable in the process of supervising electric power systems, carried out by various service centers, used to promptly inform those centers about irregularities occurring during the operation of electric power equipment.

Electric power equipment is designed for generating, converting, transmitting and using electric energy. Such equipment is required to be especially reliable and failure-free. Unexpected stoppages in their operation may cause enormous damage to entire economic systems. Also in the case of individual companies, all disturbances in the normal operation of electric power equipment employed in production processes may result in great losses for those companies. Therefore, systems supervising the operation of electric power equipment and service centers have to function together with diverse systems for monitoring and/or diagnosing such equipment. If the systems which monitor and/or diagnose irregularities during the operation of electric power equipment that can result in or actually result in interruptions in the work of that equipment, a prompt notification of the service centers of the irregularity and the quickest possible elimination of the cause of this irregularity is very important. At present, the way of communicating between the user of electric power equipment and the service may take a lot of time. For example, the operator of a piece of electric power equipment (an electric power device) informs the manager about the noticed defect and the manager makes a phone call or sends an e-mail message. Then, the service has to make a remote connection to the piece of equipment or, if that is not possible, go to the site. For that reason, reduction in the time necessary for notifying the service of the occurrence of an irregularity related to the operation of electric power equipment is of great importance for maintaining a continuous and failure free operation of the whole complex of units of electric power equipment functioning together.

The essential feature of the inventive system for monitoring and/or diagnosing of electric power equipment, and especially high voltage equipment, comprised of a monitoring and/or diagnosing unit electrically connected with the monitored and/or diagnosed electric power device and able to communicate with a receiving device located in the service center via a communication network is that the monitoring and/or diagnosing unit is connected with a trigger which is connected, via a data acquisition module, with a notification generating module able to communicate with the receiving device whose activation in the event of occurrence of irregularities related to the state of the electric power device causes an automatic generation and transfer of a notification message to the receiving device through the communications network and a network connection. The data acquisition module containing a data acquisition block collecting data about the state of the electric power device and a notification signal-tracking block.

Preferably, the trigger is a mechanical pushbutton which is placed near the electric power device and is connected with that device via one of the digital inputs, which input is monitored by the notification signal-tracking block notifying of the state of the input signal.

Preferably, the trigger is connected with a control lamp which is connected to one of the digital inputs of the electric power device.

Alternatively, the trigger is a software pushbutton.

Preferably, the software pushbutton is located on the screen of the monitoring and/or diagnosing unit, situated on the casing of the monitoring and/or diagnosing unit or of the electric power device and it is functionally connected with the data acquisition module.

Preferably, the monitoring and/or diagnosing unit is a DriveMonitor^{™} system.

The essence of the inventive method is that if irregularities concerning the state of an electric power device occur, an alarm signal is generated in the form of a message about the occurrence of an abnormal state of the electric power device, which is sent to the service center. The message generation is initiated by the activation of a trigger connected to the electric power device or to a monitoring unit linked with the electric power device. Activation of the trigger consists in pressing the trigger pushbutton by the user.

Preferably, after the activation of the trigger, data about the current state of the electric power device are automatically collected, which data are automatically attached to the generated alarm signal.

Preferably, a diagnosis about the cause of the irregularities in the state of the device, which is generated in a diagnosing module, is attached to the data describimg the current state of the electric power device.

Preferably the generated alarm signal is sent to a receiving device located in the service center, by means of a communications network and a network connection connecting the service center with the monitoring and/or diagnosing unit.

The advantage of the inventive solution concerning the method is a significant reduction in the time necessary for notifying the service center of a failure of an electric power device. The advantage of the inventive system is the simple design consisting in placing a trigger in the form of a mechanical or software pushbutton on or near the electric power device. In the event of a failure or an urgent need, pressing the pushbutton will cause the monitoring and/or diagnosing system to acquire data related to the current state of the device, which will be immediately sent to the service center by electronic mail, a text or telephone message, or any other known method of communication.

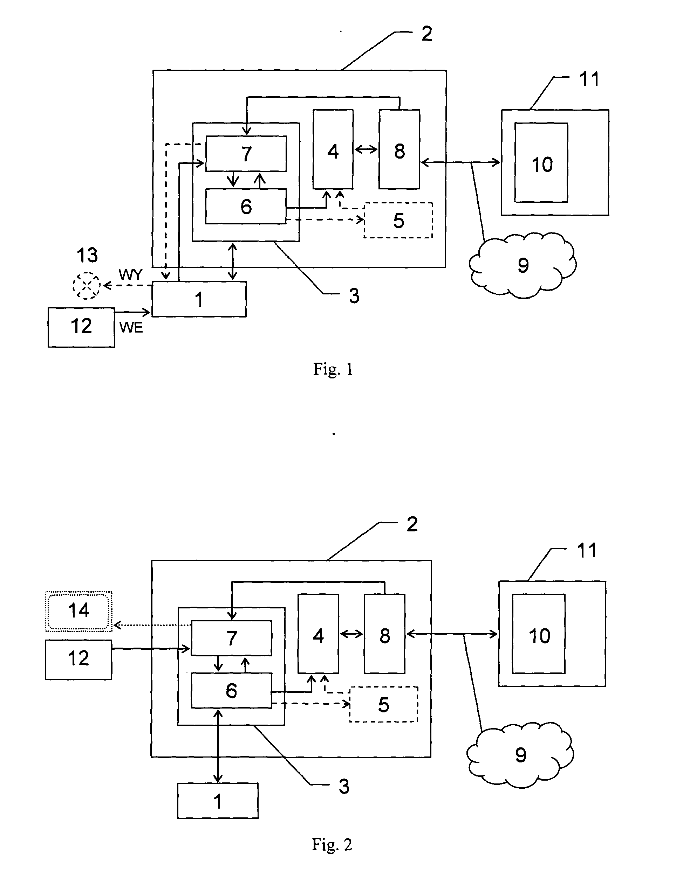

The subject of the invention is presented as an embodiment in a drawing where fig. 1 shows schematically the monitoring system implementing the method according to the first embodiment of the invention, and fig. 2 - the monitoring system implementing the method according to the second embodiment of the invention.

In both embodiments of the invention the electric power equipment monitoring and/or diagnosing system contains an electric power device 1, in the embodiment represented by a variable speed drive that is a device controlling the speed of an electric motor, which is connected with a monitoring and/or diagnosing unit 2. The monitoring and/or diagnosing unit 2 is a processor in which, in addition to the typically required modules necessary for the proper running of the monitoring and/or diagnosing process, not shown in the drawing, there are placed a data acquisition module 3, a notification generating module 4, and optionally a diagnosing module 5 used to automatically define the cause of the irregularities concerning the state of the electric power device. In the embodiment, the monitoring and/or diagnosing unit is represented by the system DriveMonitor^{™} made by ABB. In the data acquisition module 3 there is located a data acquisition block 6 collecting data about the state of the electric power device 1, in the embodiment represented by a variable speed drive, and a notification signal-tracking block 7 notifying of the status of the input signal. The diagnosing module 5 takes data from the data acquisition block 6 collecting data about the state of the drive and, based on them, diagnoses the cause of the irregularities in the state of the drive. The processor contains also a communications module 8 enabling communication by means of a network connection 9, between the monitoring and/or diagnosing unit 2 and the receiving device 10 belonging to the service center 11. The communications module 8 depending on the type of the network connection may be, for example: an Ethernet card for wire networks, a WiFi card for wireless networks or a GPRS modem for telephone networks. The data acquisition module 3 is connected with the trigger 12 activated by the device operator, which triggers an electric or digital signal which is subject to further transmission. The trigger 12 is placed near the variable speed drive and it is an element of equipment of that drive, which is shown in fig. 1, or it is an element of the monitoring and/or diagnosing unit 2, which is shown in fig. 2.

The trigger 12 in the first embodiment of the invention (fig. 1) is a mechanical pushbutton connected with a digital input I of the variable speed drive. The pushbutton status (open - closed) is recorded by the notification signal-tracking block 7, via the variable speed drive. Activation of the pushbutton (status closed) by pressing the pushbutton by the user causes the acquisition of current data in the data acquisition block 6 and transfer of these data to the notification generating module 4, from which the generated notification message is immediately transferred through the communications module 8 via the network connection 9 to the receiving device 10 located in the service center 11. If the monitoring unit 2 is provided with the diagnosing module 5, the relevant information from this module will be sent immediately after the activation of the pushbutton of the trigger 12 to the receiving device 10, via the notification generating module 4, the communications module 8 and the network connection 9, and then it will be subjected to a detailed analysis. In both cases a return message about taking corrective actions is sent from the service center 11 to the monitoring and/or diagnosing unit 2. The return information may be sent to the variable speed drive operating personnel, for instance in the form of activation of a control lamp 13 connected to the variable speed drive and controlled by the notification signal-tracking block 7 via a digital output O of the variable speed drive.

In the second embodiment of the invention, the trigger 12 is a software pushbutton which is situated on a touch screen of the monitoring and/or diagnosing unit 2 located on the casing of the unit 2, not shown in the picture, and which is functionally connected with the notification signal-tracking block 7. Activation of the pushbutton (status closed) by pressing the pushbutton by the user causes the acquisition of current data in the data acquisition block 6 and the transfer of these data to the notification generating module 4, from which the generated notification message is immediately transferred through the communications module 8 via the network connection 9 to the receiving device 10 located in the service center 11. If the monitoring unit 2 is provided with the diagnosing module 5, the relevant information from this module will be sent immediately after the activation of the pushbutton of the trigger 12 to the receiving device 10, and then it will be subjected to a detailed analysis. Optional return information sent from the service center 11 via the communications module 8 lands in the notification signal-tracking block 7 and is displayed by this block on the screen as a graphic element 14.

The method according to the invention is implemented as follows.

In the system made according to the first embodiment of the invention, monitoring of the variable speed drive is done through the monitoring and/or diagnosing unit 2, in the form of the DriveMonitor™ system. This system is connected to the Internet network via the network connection 9. One of the digital inputs I of the variable speed drive is connected to the pushbutton of the trigger 12 connected to the control lamp 13 which is connected to a digital output O of the variable speed drive. The data acquisition system loop in the monitoring and/or diagnosing system 2 monitors the status of the digital input I, that is, indirectly, the status of the trigger 12 pushbutton. The device operator, having noticed an occurrence of a state requiring the intervention of the drive service personnel, for example, inability to start the variable speed drive following a failure, presses the pushbutton of the trigger 12. The notification signal-tracking block 7 detects the pressing of the trigger 12 pushbutton by detecting a change in the value of the digital input I, and by changing the value of the digital output O it causes the control lamp 13 to light, for example in red, signaling the acknowledgment of the receipt of information about the pressing of the trigger pushbutton 12. At the same time the monitoring and/or diagnosing system 2, via the network connection 9, sends information about pressing the trigger pushbutton 12 by the user-operator and about the state of the variable speed drive to the receiving device 10 located in the service center 11. The personnel of the service center 11 can connect to the unit 2 to determine the causes of the state that has occurred and remedy them, and can also send return information which will cause the control lamp 13 to light, for instance in yellow, signaling the receipt of the service notification.

In the system made according to the second embodiment of the invention, monitoring of the drive is done by the monitoring and/or diagnosing unit 2 in the form of the DriveMonitor™ system. This system is connected to the Internet network via the network connection 9. The touch screen of the unit 2 displays a software pushbutton of the trigger 12 and a graphic element of the notification 14. The device user-operator, having noticed the occurrence of a state requiring the intervention of the drive service personnel, for example, inability to start the variable speed drive following a failure, presses the pushbutton of the trigger 12. The notification message signal tracking block 7 detects the pressing of the trigger pushbutton 12 and changes the message of the notification element 14, signaling the acknowledgment of the receipt of information about the pressing of the trigger pushbutton 12. At the same time, the diagnostic system 2, via the network connection 9, sends information about the pressing of the trigger pushbutton 12 by the operator and of the state of the drive to the receiving device 10 located in the service center 11. The personnel of the service center 11 can connect to the unit 2, to determine the causes of the state that has occurred and remedy them, and to send return information which will cause a change in the notification message element 14, signaling the receipt of the service notification.

## Claims

1. A system for monitoring and/or diagnosing electric power equipment, and especially high voltage equipment, comprised of a monitoring and/or diagnosing unit (2), electrically connected with the monitored and/or diagnosed electric power device (1), and able to communicate with a receiving device (10) located in a service center (11) via a communications network (9), **characterized in that** the monitoring and/or diagnosing unit (2) is connected with a trigger (12) which is connected via a data acquisition module (3) with a notification generating module (4) able to communicate with the receiving device (10) whose activation in the event of occurrence of irregularities related to the state of the electric power device (1) causes an automatic generation of a notification message and its transfer to the receiving device (10) through the communications network and a network connection (9), the data acquisition module (3) containing a data acquisition block (6) collecting data about the state of the device and a notification signal-tracking block (7).

2. A system according to claim 1, **characterized in that** the trigger (12) is a mechanical pushbutton which is located near the electric power device (1) and is connected with it via one of the digital inputs (I), which input is monitored by the notification signal-tracking block (7) notifying of the input signal status.

3. A system according to claim 2, **characterized in that** the trigger (12) is connected with a control lamp (13) which is connected to one of the digital outputs of the electric power device (1).

4. A system according to claim 1, **characterized in that** the trigger (12) is a software pushbutton.

5. A system according to claim 4, **characterized in that** the software pushbutton is situated on the screen of the monitoring and/or diagnosing unit (2) situated on the casing of the monitoring and/or diagnosing unit (2) or of the electric power device (1) and is functionally connected with the data acquisition module (3).

6. A system according to any of the previous claims, **characterized in that** the monitoring and/or diagnosing unit (2) is the DriveMonitor^{™} system.

7. A method for monitoring and/or diagnosing electric power equipment, and especially high voltage equipment, **characterized in that** in the event of occurrence of irregularities concerning the state of such equipment (1), an alarm signal in the form of a message about the occurrence of an irregular state of the electric power device (1) is generated and sent to the service center (11), the message generation being initiated by the activation of the trigger (12) connected to the electric power device (1) or to the monitoring unit (2) linked with the electric power device (1), which activation consists in pressing the trigger (12) pushbutton by the user.

8. A method according to claim 7, **characterized in that** after the activation of the trigger (12), data describing the current state of the electric power device (1) are automatically collected in the data acquisition block (6), and are automatically attached to the generated alarm signal.

9. A method according to claim 8 **characterized in that** a diagnosis of the cause of the irregularities in the state of the electric power device (1), which is generated in the diagnosing module (5), is attached to the data describing the current state of the device.

10. A method according to claim 7, **characterized in that** the generated alarm signal is sent to the receiving device (10) situated in the service center (11) by means of a communications network via the network connection (9) linking the service center (11) with the monitoring and/or diagnosing unit (2).
